# EUROPEAN PATENT SPECIFICATION

(11) **EP 3 154 136 B1**
(45) Date of publication and mention of the grant of the patent: **25.10.2023**
(21) Application number: 16191478.3
(22) Date of filing: 29.09.2016
(51) Int. Cl.: H01S 5/024

(54) **THERMAL-MECHANICAL ADJUSTMENT FOR LASER SYSTEM**
THERMO-MECHANISCHE ANPASSUNG FÜR LASERSYSTEM
RÉGLAGE THERMO-MÉCANIQUE POUR SYSTÈME LASER

(30) Priority: 07.10.2015 IN 3220DE2015; 14.01.2016 US 201614995558
(43) Date of publication of application: 12.04.2017
(73) Proprietor: General Electric Company, Schenectady, NY 12345 (US)
(72) Inventor: MAITY, Sandip, 560066 Bangalore, Karnataka (IN); ZHOU, Ying, Shanghai, 201203 (CN); ROBINSON, David Peter, Lisburn, Antrim BT28 2LU (GB); REFAI-AHMED, Gamal, Santa Clara, CA 95050 (US)
(74) Representative: Openshaw & Co.

(56) References cited:
- US-A1- 2003 231 690
- US-A1- 2005 123 008
- US-B1- 6 822 996

## Description

### TECHNICAL FIELD

The present invention relates generally to a laser system. In particular, the present invention relates a laser system having a thermal-mechanical adjustment device.

### BACKGROUND

Semiconductor lasers are used in many different applications. These applications can include monitoring systems and measurement systems. In a monitoring system for high-powered machinery such as a power transformer, a laser e.g., a quantum cascade laser (QCL) is used for detecting trace gases. Selection of the wavelength of the light emitted is determined by the temperature of the laser medium. Therefore, the laser assembly needs to be kept at a specific temperature to maintain accuracy of the wavelength thereof.

US 2003/231690 describes a method for optimizing feedback suppression of optical isolators when used with variable wavelength light sources. The method comprises positioning an optical isolator in a light beam, and adjusting feedback suppression by the optical isolator according to wavelength of the light beam. Adjusting the feedback suppression may comprise adjusting temperature of the optical isolator or a non-reciprocal rotator associated with the isolator.

US 2005/123008 describes a control technique and apparatus for an external cavity diode laser (ECDL). Coarse tuning adjustments for the ECDL are performed by varying the temperature of tunable filters and fine tuning adjustments may be performed varying the temperature of the ECDL base to vary the length of the cavity via thermal contraction and expansion. A controller comprises a coupler matrix that mathematically relates multiple control signal inputs for varying the temperatures of the tunable filters and base to produce multiple outputs used to control, for example, thermal-electric cooler (TEC) elements associated with the tunable filters and base.

Us 6822996 describes a laser apparatus comprising a rigid unitary mount base, a gain medium rigidly mounted with respect to the mount base in a position defining a first end of an external cavity, the gain medium having first and second output facets, a reflector rigidity mounted with respect to the mount base in a position defining a second end of the cavity, a tuning element rigidly mounted with respect to the mount base in the external cavity between the gain medium and the reflector, a collimator rigidly mounted with respect to the mount base, between a first facet of the gain medium and the tuning element and an optical output assembly rigidly mounted to the mount base and optically coupled to a second facet of the gain medium.

Current laser systems can employ a combination of fans and heat pipes to remove excess heat generated from the laser beam. However, fans can create undesired noise and vibrations, which increases the noise within the laser system.

### SUMMARY OF THE EMBODIMENTS

Embodiments of the present invention provide a laser system including a thermal-mechanical adjustment device capable of maintaining alignment of the laser beam and dissipating heat therefrom to maintain accuracy of the wavelength of the light output.

The invention resides in a laser system as defined in the appended claims.

The foregoing has broadly outlined some of the aspects and features of various embodiments, which should be construed to be merely illustrative of various potential applications of the disclosure. Other beneficial results can be obtained by applying the disclosed information in a different manner or by combining various aspects of the disclosed embodiments. Accordingly, other aspects and a more comprehensive understanding may be obtained by referring to the detailed description of the exemplary embodiments taken in conjunction with the accompanying drawings, in addition to the scope defined by the claims.

### DESCRIPTION OF THE DRAWINGS

FIG. 1 is a schematic illustrating an example of a laser system that can be implemented within one or more embodiments of the present invention.
FIG. 2 is a detailed schematic of a thermal-mechanical adjustment device of the laser system of FIG. 1 that can be implemented within one or more embodiments.
FIG. 3 is a schematic illustrating a mechanical adjustment operation of the thermal-mechanical adjustment device of FIG. 2 that can be implemented within one or more embodiments of the present invention.
FIG. 4A and 4B are schematics illustrating a heat dissipation operation of the thermal-mechanical adjustment device of FIG. 2 that can be implemented within one or more embodiments of the present invention.

The drawings are only for purposes of illustrating preferred embodiments and are not to be construed as limiting the disclosure. Given the following enabling description of the drawings, the novel aspects of the present disclosure should become evident to a person of ordinary skill in the art. This detailed description uses numerical and letter designations to refer to features in the drawings. Like or similar designations in the drawings and description have been used to refer to like or similar parts of embodiments of the invention.

### DETAILED DESCRIPTION OF THE EMBODIMENTS

As required, detailed embodiments are disclosed herein. It must be understood that the disclosed embodiments are merely exemplary of various and alternative forms. As used herein, the word "exemplary" is used expansively to refer to embodiments that serve as illustrations, specimens, models, or patterns. The figures are not necessarily to scale and some features may be exaggerated or minimized to show details of particular components. In other instances, well-known components, systems, materials, or methods that are known to those having ordinary skill in the art have not been described in detail in order to avoid obscuring the present disclosure. Therefore, specific structural and functional details disclosed herein are not to be interpreted as limiting, but merely as a basis for the claims and as a representative basis for teaching one skilled in the art.

Embodiments of the present invention provide a laser system housing a laser holder for transmitting a laser beam therethrough, and a thermal-mechanical adjustment device capable of adjusting the temperature of the laser beam and maintaining the alignment of the laser beam. The thermal-mechanical adjustment device effectively maintains accuracy of the wavelength of the light output.

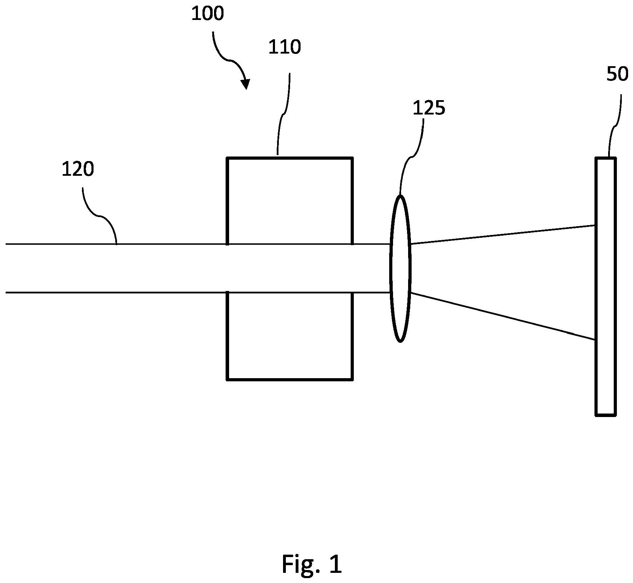

Details regarding the laser system 100 of the present invention will now be discussed with reference to FIGS. 1 through 3. FIG. 1 illustrates a laser system 100 used to perform various testing operations on target equipment 50 e.g., such as a power transformer. For example, the testing operations can include trace gases detection. The laser system 100 can be a semiconductor laser such as a quantum cascade laser (QCL). Other types of lasers could also be used with this laser system 100, for example telecommunication lasers, lead salt lasers, vertical cavity surface emitting laser (VCSEL), Hybrid silicon laser, InGaAsp laser, semiconductor laser diode, doped insulator lasers, or gas and chemical lasers, etc.

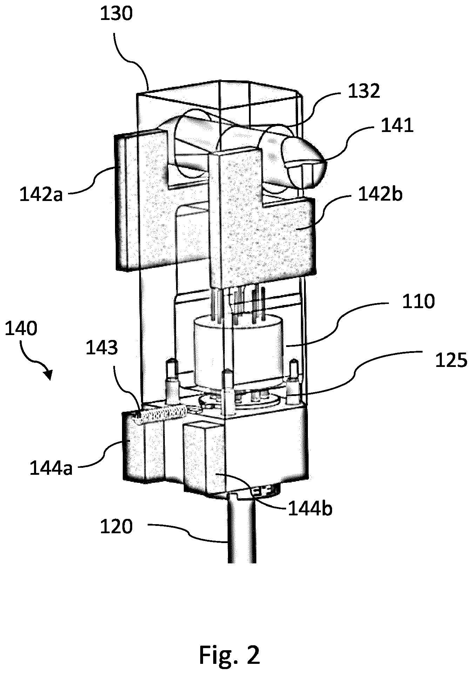

As further shown in FIG. 1, the laser system 100 includes a laser holder 110 for transmitting a laser beam 120 therethrough emitting from a laser source. One or more lens 125 are disposed downstream of the laser holder 110 for reflecting the laser beam 120 in a desired direction. In Fig. 2, the laser system 100 further includes a laser head (i.e., a mounting stand) 130 adjacent to the laser holder 110 holding the laser beam 120 and lens 125. The laser head 130 includes a chamfered opening 132, and a thermal-mechanical adjustment device 140 including a pivot bar 141 for maintaining the alignment of the laser beam 120. The laser head 130 can be formed of a metal material such as copper or any other suitable material.

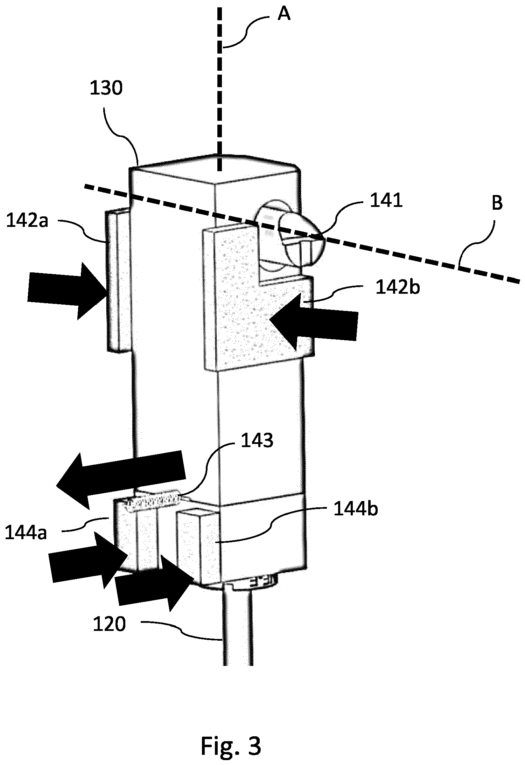

Further in FIG. 2, the chamfered opening 132 of the laser head 130 is formed at one end of the laser head 130 opposite the emitting end of the laser beam 120 from the laser source, and is configured to house the pivot bar 141 therein. The pivot bar 141 is configured to allow pivot in conjunction with the chamfered opening and rotation of the laser beam 120 about its circumference at a pivot point (as depicted by dashed line 'A' in FIG. 3). The chamfered opening 132 is configured to allow the pivot bar 141 to sway at an angle of approximately 90° to the rotation of the pivot bar 141 (as depicted by dashed line 'B' in FIG. 3). Thus, the pivot bar 141 allows x and y axis alignment of the laser beam 120. When only 1-axis alignment is needed, the rotation around the pivot bar. Alternatively, when 2-axis alignment is needed, then both rotation and pivoting operations are performed.

The thermal-mechanical adjustment device 140 of the laser system 100 further includes a plurality of first thermally conductive portions 142a and 142b disposed at opposite sides of the laser head 130 adjacent to respective ends of the pivot bar 141. According to one or more embodiments, the thermally conductive portions 142a and 142b can be formed of thermally conductive foam or any other suitable material for the purposes set forth herein.

A spring device 143 is also provided and is disposed at along the laser head 130 at another end of the laser head 130 opposite the end housing the pivot bar 141. Additionally, according to one or more embodiments, second thermally conductive portions 144a and 144b are disposed adjacent to the spring device 143. The second thermally conductive portions 144a and 144b can be formed of the same or different materials than that of the first thermally conductive portions 142a and 142b. The thermally conductive foam of the thermally conductive portions 142a, 142b, 144a and 144b provides a resistive force and has elastic restorative properties as well as being thermally conductive. Thus, the material could be used in conjunction with screws to allow precise alignment.

As shown in FIG. 2, the first thermally conductive portions 142a and 142b are L-shaped and the second thermally conductive portions 144a and 144b are rectangular-shaped. The present invention is not limited to the thermally conductive portions 142a, 142b, 144a and 144b being any particular shape or size, and may vary accordingly. Details regarding the operations of the first and second thermally conductive portions 142a, 142b, 144a and 144b and the spring device 143 will be discussed now with reference to FIGS. 3 through 4B.

FIG. 3 is a schematic illustrating a mechanical adjustment operation to be performed by the thermal-mechanical adjustment device 140 according to one or more embodiments of the present invention.

As shown in FIG. 3, as indicated by the arrows, the first and second thermally conductive portions 142a, 142b, 144a and 144b are configured to apply a resistive (i.e., pushing) force to the laser head 130, while the spring device 143 is configured to apply a pulling force to the laser head 130, to assist with adjustment of the laser beam 120 being transmitted therethrough.

When the laser beam 120 is transmitted through the laser head 130, the first and second thermally conductive portions 142a, 142b, 144a and 144b along with the spring device 143 maintain the alignment of the laser beam, thereby maintaining the accuracy of the wavelength. The first and second thermally conductive portions 142a, 142b, 144a and 144b also dissipate heat from the laser system 100.

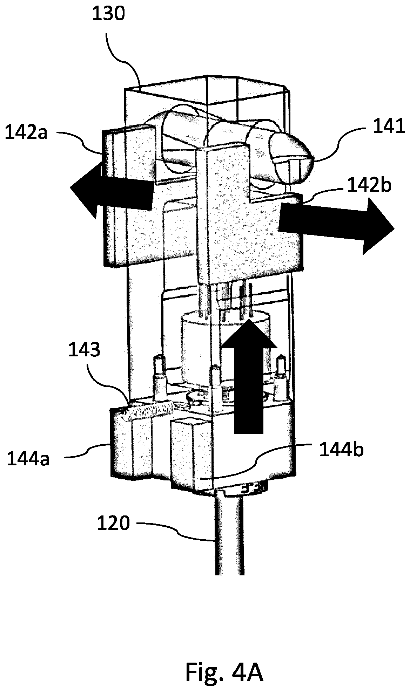

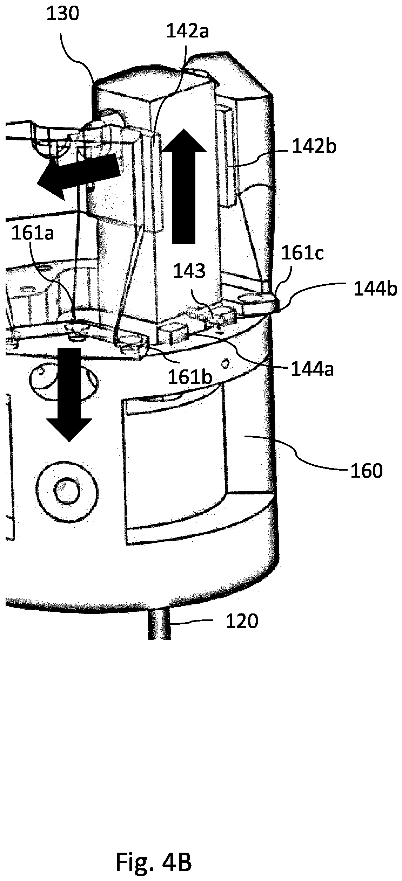

FIG. 4A and 4B are schematics illustrating a heat dissipation operation of the thermal-mechanical adjustment device 140 that can be implemented within one or more embodiments of the present invention.

As shown in FIG. 4A, as indicated by the arrows, the first and second thermally conductive portions 142a, 142b, 144a and 144b are further configured to transfer heat generated by the laser beam 120 away from the laser head 130. Thus, the first and second thermally conductive portions 142a, 142b, 144a and 144b assist with maintaining the temperature of the laser beam 120 to a specific temperature range of approximately 20 to 40 degrees Celsius.

In some embodiments, the laser system 100 can be mounted to a mounting base 160 as shown in FIG. 4B. In this embodiment, the laser head 130 is secured to mounting base 160 via one or more set screws 161a, 161b and 161c. The first and second thermally conductive portions 144a and 144b are further configured to apply a pushing force against the force of the set screws 161a, 161b and 161c to maintain accuracy of the alignment of the laser beam 120.

Further, the heat transferred away from the laser head 130 via the first and second thermally conductive portions 142a, 142b, 144a and 144b is further transferred to the mounting base 160 to be dissipated therefrom (as indicated by the arrows). The heat can be disposed of via a heat pipe, heat sink or other heat dissipating mechanism attached to the mounting base 160. The laser system 100 of the present invention therefore effectively maintains the temperature of the laser beam 120.

Embodiments of the present invention provides the advantages of dissipating heat and mechanically aligning the laser beam of the laser system using the same components (i.e., the thermally conductive portions) employed therein. Further, the present invention provides a laser system without use of a fan to thereby avoid unwanted noise and vibrations in the laser system.

This written description uses examples to disclose the invention including the best mode, and also to enable any person skilled in the art to practice the invention, including making and using any devices or systems and performing any incorporated methods.

## Claims

1. A laser system (100) comprising:
a laser holder (110) for transmitting a laser beam therethrough emitted from a laser source;
a lens (125) disposed downstream of the laser holder (110) for focusing the laser beam (120);
a laser head (130) adjacent to the laser holder (110), the laser head (130) holding the lens (125); wherein
the laser head (130) includes:
a thermal-mechanical adjustment device (140); and
an opening (132) formed at one end of the laser head (130) opposite an end through which the laser beam (120) is emitted from the laser head;
the thermal-mechanical adjustment device (140) includes a pivot bar (141) disposed within the opening (132);
the opening (132) includes opposed open ends and a pivot point in between the opposed open ends, wherein a first cross-sectional area of the opening (132) at a first one of the opposed open ends is greater than a second cross-sectional area of the opening (132) at the pivot point and wherein a third cross-sectional area of the opening (132) at a second one of the opposed open ends is greater than the second cross-sectional area of the opening (132) at the pivot point and
the pivot bar (141) is configured to pivot about the pivot point and to rotate about its axis (B), so as to vary the alignment of the laser beam (120) at the end of the laser head (130) through which the laser beam (120) is emitted.

2. The laser system (100) of claim 1, wherein the thermal-mechanical adjustment device (140) comprises:
a plurality of first thermally conductive portions (142a, 142b) disposed at opposite sides of the laser head (130) adjacent to respective ends of the pivot bar (141) and configured to apply a pushing inward force to the laser head (130).

3. The laser system (100) of claim 2, wherein the first thermally conductive portions (142a, 142b) comprise a foam material.

4. The laser system (100) of claim 2 or 3, wherein the thermal-mechanical adjustment device (140) further comprises:
a spring device (143) disposed at the opposite end of the laser head (130) and configured to apply a pulling force to the laser head (130); and
a plurality of second thermally conductive portions (144a, 144b) disposed adjacent to the spring device (143) and configured to apply a pushing inward force to the laser head (130).

5. The laser system (100) of claim 4, further comprising:
a mounting base (160) configured to mount the laser head (130) thereon; and
a plurality of set screws (161a, 161b, 161c) to secure the laser head (130) to the mounting base (160), wherein the second thermally conductive portions (144a, 144b) are configured to apply a pushing inward force against the plurality of set screws (161a, 161b, 161c) to maintain alignment of the laser beam (120) within the laser head (130).

## Patentansprüche

1. Lasersystem (100), umfassend:
einen Laserhalter (110) zum Durchlassen eines von einer Laserquelle emittierten Laserstrahls;
eine Linse (125), die stromabwärts des Laserhalters (110) angeordnet ist, um den Laserstrahl (120) zu fokussieren;
einen Laserkopf (130) neben dem Laserhalter (110), wobei der Laserkopf (130) die Linse (125) hält; wobei
der Laserkopf (130) Folgendes beinhaltet:
eine thermisch-mechanische Einstellvorrichtung (140); und
eine Öffnung (132), die an einem Ende des Laserkopfs (130) gegenüber einem Ende ausgebildet ist, durch das der Laserstrahl (120) vom Laserkopf emittiert wird;
die thermisch-mechanische Einstellvorrichtung (140) eine Schwenkstange (141) beinhaltet, die in der Öffnung (132) angeordnet ist;
die Öffnung (132) gegenüberliegende offene Enden und einen Drehpunkt zwischen den gegenüberliegenden offenen Enden beinhaltet, wobei eine erste Querschnittsfläche der Öffnung (132) an einem ersten der gegenüberliegenden offenen Enden größer ist als eine zweite Querschnittsfläche der Öffnung (132) am Drehpunkt und wobei eine dritte Querschnittsfläche der Öffnung (132) an einem zweiten der gegenüberliegenden offenen Enden größer ist als die zweite Querschnittsfläche der Öffnung (132) am Drehpunkt und
die Schwenkstange (141) so konfiguriert ist, dass sie um den Drehpunkt schwenkt und sich um ihre Achse (B) dreht, um so die Ausrichtung des Laserstrahls (120) am Ende des Laserkopfs (130), durch den der Laserstrahl (120) emittiert wird, zu variieren.

2. Lasersystem (100) nach Anspruch 1, wobei die thermisch-mechanische Einstellvorrichtung (140) Folgendes umfasst:
eine Vielzahl erster wärmeleitender Abschnitte (142a, 142b), die an gegenüberliegenden Seiten des Laserkopfs (130) neben den jeweiligen Enden der Schwenkstange (141) angeordnet und so konfiguriert sind, dass sie eine nach innen drückende Kraft auf den Laserkopf (130) ausüben.

3. Lasersystem (100) nach Anspruch 2, wobei die ersten wärmeleitenden Abschnitte (142a, 142b) ein Schaumstoffmaterial umfassen.

4. Lasersystem (100) nach Anspruch 2 oder 3, wobei die thermisch-mechanische Einstellvorrichtung (140) weiter Folgendes umfasst:
eine Federvorrichtung (143), die am gegenüberliegenden Ende des Laserkopfs (130) angeordnet und so konfiguriert ist, dass sie eine Zugkraft auf den Laserkopf (130) ausübt; und
eine Vielzahl zweiter wärmeleitender Abschnitte (144a, 144b), die neben der Federvorrichtung (143) angeordnet und so konfiguriert sind, dass sie eine nach innen drückende Kraft auf den Laserkopf (130) ausüben.

5. Lasersystem (100) nach Anspruch 4, weiter umfassend:
eine Montagebasis (160), die so konfiguriert ist, dass der Laserkopf (130) darauf montiert wird, und
eine Vielzahl von Stellschrauben (161a, 161b, 161c), um den Laserkopf (130) an der Montagebasis (160) zu befestigen, wobei die zweiten wärmeleitenden Abschnitte (144a, 144b) so konfiguriert sind, dass sie eine nach innen drückende Kraft gegen die Vielzahl von Stellschrauben (161a, 161b, 161c) ausüben, um die Ausrichtung des Laserstrahls (120) im Laserkopf (130) aufrechtzuerhalten.

## Revendications

1. Système laser (100), comprenant :
un support de laser (110) pour transmettre à travers celui-ci un faisceau laser émis depuis une source laser ;
une lentille (125) disposée en aval du support de laser (110) pour focaliser le faisceau laser (120) ;
une tête de laser (130) adjacente au support de laser (110), la tête de laser (130) supportant la lentille (125) ; dans lequel
la tête de laser (130) inclut :
un dispositif d'ajustement thermomécanique (140) ; et
une ouverture (132) formée à une extrémité de la tête de laser (130) opposée à une extrémité à travers laquelle le faisceau laser (120) est émis depuis la tête de laser ;
le dispositif d'ajustement thermomécanique (140) inclut une barre pivotante (141) disposée à l'intérieur de l'ouverture (132) ;
l'ouverture (132) inclut des extrémités ouvertes opposées et un point de pivotement entre les extrémités ouvertes opposées, dans lequel une première zone de section transversale de l'ouverture (132) au niveau d'une première des extrémités ouvertes opposées est supérieure à une deuxième zone de section transversale de l'ouverture (132) au niveau du point de pivotement et dans lequel une troisième zone de section transversale de l'ouverture (132) au niveau d'une seconde des extrémités ouvertes opposées est supérieure à la deuxième zone de section transversale de l'ouverture (132) au niveau du point de pivotement, et
la barre pivotante (141) est configurée pour pivoter autour du point de pivotement et pour tourner autour de son axe (B), de manière à faire varier l'alignement du faisceau laser (120) à l'extrémité de la tête de laser (130) à travers laquelle le faisceau laser (120) est émis.

2. Système laser (100) selon la revendication 1, dans lequel le dispositif d'ajustement thermomécanique (140) comprend :
une pluralité de premières parties thermoconductrices (142a, 142b) disposées sur des côtés opposés de la tête de laser (130) adjacentes aux extrémités respectives de la barre pivotante (141) et configurées pour appliquer une force de poussée vers l'intérieur à la tête de laser (130).

3. Système laser (100) selon la revendication 2, dans lequel les premières parties thermoconductrices (142a, 142b) comprennent un matériau en mousse.

4. Système laser (100) selon la revendication 2 ou 3, dans lequel le dispositif d'ajustement thermomécanique (140) comprend en outre :
un dispositif à ressort (143) disposé à l'extrémité opposée de la tête de laser (130) et configuré pour appliquer une force de traction à la tête de laser (130) ; et
une pluralité de secondes parties thermoconductrices (144a, 144b) disposées de manière adjacente au dispositif à ressort (143) et configurées pour appliquer une force de poussée vers l'intérieur à la tête de laser (130).

5. Système laser (100) selon la revendication 4, comprenant en outre :
une base de montage (160) configurée pour monter la tête de laser (130) sur celle-ci ; et
une pluralité de vis de réglage (161a, 161b, 161c) pour fixer la tête de laser (130) à la base de montage (160), dans lequel les secondes parties thermoconductrices (144a, 144b) sont configurées pour appliquer une force de poussée vers l'intérieur contre la pluralité de vis de réglage (161a, 161b, 161c) afin de maintenir l'alignement du faisceau laser (120) à l'intérieur de la tête de laser (130).
